(19) Europäisches Patentamt / European Patent Office / Office européen des brevets

(11) **EP 3 088 568 B1**

(12) **EUROPEAN PATENT SPECIFICATION**

(45) Date of publication and mention
of the grant of the patent:
**01.01.2020 Bulletin 2020/01**

(21) Application number: **14834058.1**

(22) Date of filing: **18.11.2014**

(51) Int Cl.:
*C23C 28/04* (2006.01)    *C23C 8/24* (2006.01)
*C23C 8/80* (2006.01)    *C25D 11/26* (2006.01)
*A47J 37/12* (2006.01)    *C22F 1/18* (2006.01)

(86) International application number:
**PCT/JP2014/080413**

(87) International publication number:
**WO 2015/020238 (12.02.2015 Gazette 2015/06)**

(54) **A METHOD FOR PRODUCING AN EDIBLE OIL DEGRADATION-PREVENTING MEMBER**

EIN VERFAHREN ZUR HERSTELLUNG EINES ELEMENTS ZUR VERHINDERUNG DER ZERSETZUNG VON SPEISEÖL

UN PROCÉDÉ POUR PRODUIRE UN ÉLÉMENT EMPÊCHANT LA DÉTÉRIORATION D'UNE HUILE COMESTIBLE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **27.12.2013 JP 2013272308**

(43) Date of publication of application:
**02.11.2016 Bulletin 2016/44**

(73) Proprietor: **Showa Co., Ltd.**
**Ikoma-city, Nara 6300142 (JP)**

(72) Inventors:
• **TAKAYASU, Teruki**
**Ikoma-city**
**Nara 630-0142 (JP)**

• **MORI, Shingo**
**Osaka-shi**
**Osaka 542-0081 (JP)**

(74) Representative: **Vossius & Partner**
**Patentanwälte Rechtsanwälte mbB**
**Siebertstrasse 3**
**81675 München (DE)**

(56) References cited:
**EP-A1- 1 930 479**    **WO-A1-2007/023543**
**JP-A- H 059 790**    **JP-A- H0 919 612**
**JP-A- H08 109 497**    **JP-A- H08 246 192**
**JP-A- H09 263 929**    **JP-A- H11 279 749**
**JP-A- 2001 199 725**    **JP-A- 2005 240 139**
**JP-A- 2005 240 139**    **JP-A- 2009 097 060**
**JP-A- 2011 200 406**    **US-A1- 2013 186 813**

**Description**

Technical Field

The present invention relates to a method for treating the surface of a metallic titanium material or titanium alloy material useful for an edible oil degradation-preventing member, and an edible oil degradation-preventing member obtained by the surface-treating method.

Background Art

Edible oil, such as tempura oil and soybean oil, is known to be degraded by heating at high temperatures for a long time, deteriorating the flavor and nutritional value.

To solve this problem, Patent Literature 1 proposes a technique of filtering degraded edible oil for recycling. However, this technique is treatment using a filtering medium or the like, not a technique for suppressing the degradation of edible oil itself.

To prevent edible oil from degrading, Patent Literature 2 proposes a technique using a member produced by (i) forming titanium nitride on the surface of metallic titanium; (ii) anodizing the metallic titanium by applying a voltage equal to or higher than a sparkover voltage in an electrolyte solution containing an acid having an etching effect on metallic titanium; and (iii) forming anatase-type titanium oxide on the surface of the metallic titanium.

However, this technique requires the use of hazardous strong acids, such as sulfuric acid, to perform etching on highly corrosion-resistant metallic titanium. In addition, anodization under a voltage equal to or higher than the sparkover voltage requires a very expensive electric power source capable of outputting high voltage and high current.

Such anodization also requires cooling equipment for controlling the exotherm of the electrolyte solution caused by spark discharge, resulting in high cost for producing an edible oil degradation-preventing member.

Citation List

Patent Literature

   Patent Literature 1: JPH09-19612A
   Patent Literature 2: JP2011-200406A & US 2013/0186813

Summary of Invention

Technical Problem

An object of the present invention is to produce a member useful for preventing edible oil from degrading by performing simple, economical, and safe steps.

Solution to Problem

The present inventors conducted extensive research to achieve the object and found that the following surface-treating method can produce a material useful for preventing edible oil from degrading: the method comprises the steps of

   (1) forming titanium nitride on the surface of a metallic titanium material or titanium alloy (i.e., an alloy largely composed of titanium) material by one treatment method selected from the group consisting of a heat treatment under an ammonia gas atmosphere and a heat treatment under a nitrogen gas atmosphere, at a heating temperature of 750°C or higher;
   (2) anodizing the metallic titanium material or titanium alloy material by applying a voltage of 10 V or more in an electrolyte solution having no etching effect on titanium, thereby forming a titanium oxide film; and
   (3) heating the metallic titanium material or titanium alloy material at a temperature of 400°C or higher in an atmosphere selected from an air atmosphere, a mixed atmosphere of oxygen gas and nitrogen gas, and an oxygen gas atmosphere.

Specifically, the present invention is directed to the following method for producing an edible oil degradation-preventing member and the edible oil degradation-preventing member.

Item 1. A method for producing an edible oil degradation-preventing member, the method comprising the steps of:

(1) forming titanium nitride on the surface of a metallic titanium material or titanium alloy material by one treatment method selected from the group consisting of a heat treatment under an ammonia gas atmosphere and a heat treatment under a nitrogen gas atmosphere, at a heating temperature of 750°C or higher;
(2) anodizing the metallic titanium material or titanium alloy material with the titanium nitride formed on the surface thereof obtained in step (1) by applying a voltage of 10 V or more in an electrolyte solution having no etching effect on titanium, thereby forming a titanium oxide film; and
(3) heating the metallic titanium material or titanium alloy material with the titanium oxide film formed on the surface thereof obtained in step (2) at a temperature of 400°C or higher in an atmosphere selected from an air atmosphere, a mixed atmosphere of oxygen gas and nitrogen gas, and an oxygen gas atmosphere.

Item 2. The method for producing an edible oil degradation-preventing member according to Item 1, wherein the heat treatment under a nitrogen gas atmosphere is performed in the presence of an oxygen-trapping agent.

Item 3. The method for producing an edible oil degradation-preventing member according to Item 1 or 2, wherein the electrolyte solution having no etching effect on titanium for use in the anodization contains at least one compound selected from the group consisting of inorganic acids, organic acids, and salts thereof.

Item 4. The method for producing an edible oil degradation-preventing member according to Item 3, wherein the at least one compound selected from the group consisting of inorganic acids, organic acids, and salts thereof is at least one compound selected from the group consisting of phosphoric acid and phosphate.

Item 5. The method for producing an edible oil degradation-preventing member according to any one of Items 1 to 4, wherein the voltage applied in the anodization of step (2) is 50 to 300 V.

Item 6. The method for producing an edible oil degradation-preventing member according to any one of Items 1 to 5, wherein the temperature of the heat treatment performed in the atmosphere of step (3) is 400°C to 700°C.

Item 7. The method for producing an edible oil degradation-preventing member according to any one of Items 1 to 6, wherein the titanium oxide film formed by the anodization is a crystalline titanium oxide film.

Item 8. The method for producing an edible oil degradation-preventing member according to Item 7, wherein the crystalline titanium oxide film is an anatase-type titanium oxide film.

Advantageous Effects of Invention

The present invention enables the production of a member useful for preventing edible oil from degrading by performing simple, economical, and safe steps. Simply bringing the edible oil degradation-preventing member into contact with edible oil during heating can prevent the edible oil from degrading.

Brief Description of Drawings

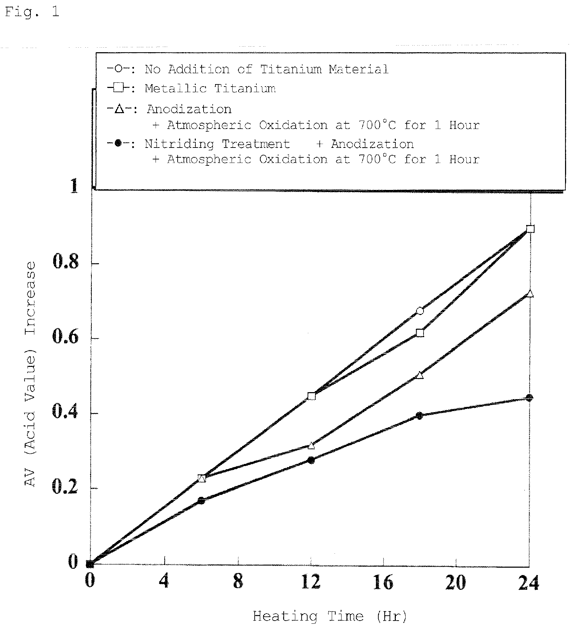

Fig. 1 shows the heating time of soybean oil and the acid value (AV) of the soybean oil, which indicates the degree of degradation of edible oil.

Description of Embodiments

The following describes the present invention in detail. In the present specification, the metallic titanium material and titanium alloy material are also referred to as simply a "titanium material."

The method for producing a surface-treated metallic titanium material or titanium alloy material useful for the edible oil degradation-preventing member according to the present invention comprises the steps of:

(1) forming titanium nitride on the surface of a metallic titanium material or titanium alloy (i.e., an alloy largely composed of titanium) material by one treatment method selected from the group consisting of a heat treatment under an ammonia gas atmosphere and a heat treatment under a nitrogen gas atmosphere, at a heating temperature of 750°C or higher;
(2) anodizing the metallic titanium material or titanium alloy material with the titanium nitride formed on the surface thereof obtained in step (1) by applying a voltage of 10 V or more in an electrolyte solution having no etching effect on titanium, thereby forming a titanium oxide film; and
(3) heating the metallic titanium material or titanium alloy material with the titanium oxide film formed on the surface thereof obtained in step (2) at a temperature of 400°C or higher in an atmosphere selected from (the group consisting of) an air atmosphere, a mixed atmosphere of oxygen gas and nitrogen gas, and an oxygen gas atmosphere.

## (1) Step of Forming Titanium Nitride

The method for producing a surface-treated metallic titanium material or titanium alloy material (titanium material) comprises the step of forming titanium nitride on the surface of a metallic titanium material or titanium alloy material.

When a titanium alloy material is used in the present invention, its type is not particularly limited. Examples of titanium alloys include Ti-6Al-4V, Ti-4.5Al-3V-2Fe-2Mo, and Ti-0.5Pd. The metallic titanium material is titanium itself.

In this step, a layer of titanium nitride is formed on the surface of a titanium material to a thickness of typically about 0.1 to 100 $\mu$m, preferably about 0.5 to 50 pm, and more preferably about 1 to 10 $\mu$m.

In the technique of forming titanium nitride on the surface of a titanium material, the heating temperature of the heat treatment under an ammonia gas or nitrogen gas atmosphere is 750°C or higher, preferably about 750 to 1,050°C, and more preferably about 750°C to 950°C. It is preferable to heat a titanium material typically at about 750°C or higher under a nitrogen gas atmosphere.

The heat treatment under an ammonia gas or nitrogen gas atmosphere is preferably performed in the presence of an oxygen-trapping agent. The oxygen-trapping agent used in the heat treatment of a titanium material is, for example, a substance or gas having a higher oxygen affinity than that of the titanium material. For example, a carbon material, metallic powder, or hydrogen gas can be used. These oxygen-trapping agents may be used singly or in a combination of two or more.

Examples of carbon materials include, but are not particularly limited to, graphite carbon, amorphous carbon, and carbon having an intermediate crystal structure between graphite carbon and amorphous carbon. The carbon material may have any shape, such as a plate, a foil, or a powder. It is preferable to use a plate-shaped carbon material (or two or more plate-shaped carbon materials) from the standpoint of handling properties and the prevention of thermal strain in the titanium material during heat treatment.

Examples of metallic powders include, but are not particularly limited to, metallic powders of titanium, a titanium alloy, chromium, a chromium alloy, molybdenum, a molybdenum alloy, vanadium, a vanadium alloy, tantalum, a tantalum alloy, zirconium, zirconium, a zirconium alloy, silicon, a silicon alloy, aluminum, and an aluminum alloy.

It is preferable to use a metallic powder of titanium, a titanium alloy, chromium, a chromium alloy, zirconium, a zirconium alloy, aluminum, an aluminum alloy, or the like, because of their high oxygen affinity. The most preferable metallic powder is a metallic powder of particulate titanium or titanium alloy. These metallic powders may be used singly or in a combination of two or more.

The average particle diameter of the metallic powder is preferably about 0.1 to 1,000 pm, more preferably about 0.1 to 100 $\mu$m, and even more preferably about 0.1 to 10 $\mu$m.

The conditions for using an oxygen-trapping agent in an ammonia gas or nitrogen gas atmosphere can be suitably determined depending on the type and shape of the oxygen-trapping agent.

For example, when a carbon material or metallic powder is used as the oxygen-trapping agent, a titanium material is brought into contact with the carbon material or metallic powder so that the surface of the titanium material is covered with the carbon material or metallic powder. Then, the titanium material is heated under an ammonia gas or nitrogen gas atmosphere.

Alternatively, when hydrogen gas is used as the oxygen-trapping agent, the titanium material is heated while hydrogen gas is introduced into an ammonia gas or nitrogen gas atmosphere.

The heat treatment can be performed in an atmosphere of ammonia gas, nitrogen gas, or a mixed gas of ammonia gas and nitrogen gas. It is most preferable to use nitrogen gas from the standpoint of simplicity, economy, and safety.

The reaction pressure for the heat treatment under an ammonia gas or nitrogen gas atmosphere is about 0.01 to 100 MPa, preferably about 0.1 to 10 MPa, and more preferably about 0.1 to 1 MPa. The heat treatment is preferably performed under a nitrogen gas atmosphere.

The heating time for the heat treatment under an ammonia gas or nitrogen gas atmosphere is preferably about 1 minute to 12 hours, more preferably about 10 minutes to 8 hours, and even more preferably about 1 hour to 6 hours. It is preferable to heat the titanium material for this period of time.

When a titanium material is heated under an ammonia gas or nitrogen gas atmosphere, it is preferable, in order to efficiently form titanium nitride on the surface of the titanium material, to reduce the pressure in the furnace for heat treatment using a rotary vacuum pump optionally with a mechanical booster pump or an oil diffusion pump, and to reduce the concentration of oxygen remaining in the furnace for heat treatment (i.e., in the nitriding furnace).

Titanium nitride can be efficiently formed on the surface of a titanium material by reducing the pressure in the furnace for heat treatment to preferably about 10 Pa or less, more preferably about 1 Pa or less, and even more preferably about 0.1 Pa or less.

Titanium nitride can be efficiently formed on the surface of a titanium material by supplying ammonia gas, nitrogen gas, or a mixed gas of ammonia gas and nitrogen gas, into the decompressed furnace to return the pressure in the furnace, and heating the titanium material. The heating temperature, heating time, and other conditions of the heat treatment using this furnace may be the same as the above-mentioned conditions. For the gas composition, it is most preferable to use nitrogen gas from the standpoint of simplicity, economy, and safety.

Titanium nitride can be more efficiently formed on the surface of a titanium material by alternately repeating (several times) the decompression treatment for reducing the concentration of oxygen remaining in the furnace for heat treatment, and the pressure-returning treatment for supplying nitrogen gas, or other gas into the furnace.

Furthermore, titanium nitride can be more efficiently formed on the surface of a titanium material by performing the decompression treatment in the presence of an oxygen-trapping agent, and the heat treatment under a gas atmosphere, such as ammonia gas or nitrogen gas.

The type of titanium nitride formed on the surface of a titanium material is not particularly limited. Examples thereof include TiN, $Ti_2N$, $\alpha$-$TiN_{0.3}$, $\eta$-$Ti_3N_{2-x}$, $\zeta$-$Ti_4N_{3-x}$ (provided that X is 0 or more and less than 3), mixtures thereof, and amorphous titanium nitride. Preferred among these are TiN, $Ti_2N$, and mixtures thereof; more preferred are TiN, and a mixture of TiN and $Ti_2N$; and particularly preferred is TiN.

In the present invention, as the technique for forming titanium nitride, one of the above methods may be used singly, or two or more of them may be used in combination. Of the above methods for forming titanium nitride, the heat treatment of a titanium material under nitrogen gas atmosphere is preferable from the standpoint of simplicity, mass production, or production cost.


(2) Step of Performing Anodization

The method for producing a surface-treated metallic titanium material or titanium alloy material for an edible oil degradation-preventing member comprises the step of anodizing the metallic titanium material or titanium alloy material with titanium nitride formed on the surface thereof in an electrolyte solution having no etching effect on titanium to thereby form a titanium oxide film. The electrolyte solution having no etching effect on titanium preferably contains at least one acid selected from the group consisting of inorganic acids and organic acids, or a salt compound thereof.

An amorphous titanium oxide film is formed on the surface of a titanium material by anodizing the titanium material with titanium nitride formed on the surface thereof in an electrolyte solution having no etching effect on titanium by applying a voltage of 10 V or more.

The electrolyte solution having no etching effect on titanium is preferably an electrolyte solution containing at least one compound selected from the group consisting of inorganic acids, organic acids, and salts thereof (hereinafter also referred to as "an inorganic acid or the like"). The electrolyte solution containing an inorganic acid or the like is preferably a dilute aqueous solution of phosphoric acid, phosphate, or the like.

Only performing the step of anodization of the present invention does not generate crystalline titanium oxide, such as anatase-type titanium oxide (anatase-type titanium dioxide). Anatase-type titanium oxide can be formed from amorphous titanium oxide in the subsequent heat treatment step.

Because an amorphous titanium oxide film is effectively formed on the surface of a titanium material, it is essential to anodize a titanium material with titanium nitride formed on the surface thereof.

Performing the anodization step between the above-described titanium nitride formation step and the below-described heat treatment step enables the production of a member capable of preventing edible oil from degrading.

The anodization step of the present invention is highly safe because strong acids (e.g., sulfuric acid) that have an etching effect on titanium are not used.

The anodization step of the present invention does not require high voltage or high current because etching accompanied by the spark discharge phenomena is not performed on titanium. Because the anodization step does not require the use of expensive power units that provide high current and high voltage, or the use of high power associated with high current and high voltage, the step is highly economical.

In anodization, it is essential to use an electrolyte solution having no etching effect on titanium from the standpoint of simplicity, economy, safety, and the like. The electrolyte solution having no etching effect on titanium is preferably an electrolyte solution containing at least one compound (an inorganic acid or the like) selected from the group consisting of inorganic acids (e.g., phosphoric acid), organic acids, and salts thereof (e.g., phosphate).

The inorganic acid having no etching effect on titanium, is preferably phosphoric acid, carbonic acid, or the like from the standpoint of simplicity, economy, safety, or the like. The organic acid having no etching effect on titanium is preferably acetic acid, adipic acid, lactic acid, or the like.

Salts of these acids, such as sodium dihydrogenphosphate, disodium hydrogenphosphate, sodium hydrogencarbonate, sodium acetate, potassium adipate, and sodium lactate, can also be used.

In addition, it is preferable to use an electrolyte solution containing an electrolyte, such as sodium sulfate, potassium sulfate, magnesium sulfate, sodium nitrate, potassium nitrate, magnesium nitrate, or calcium nitrate.

The most preferable inorganic acids are phosphoric acid and phosphate.

The electrolyte solution is preferably a dilute aqueous solution of an inorganic acid or the like. An electrolyte solution containing an inorganic acid or the like preferably has a concentration of about 1 wt.% from the standpoint of economy. For example, an electrolyte solution containing phosphoric acid preferably has a concentration of about 0.01 to 10 wt.%, more preferably about 0.1 to 10 wt.%, and even more preferably about 1 to 3 wt.%.

These acids may be used singly, or in a combination of any two or more regardless of whether they are organic acids or inorganic acids. A preferable embodiment of an electrolyte solution containing two or more acids is, for example, an aqueous solution containing phosphate and phosphoric acid.

The proportion of the acids in this electrolyte solution varies depending on the type of acid and acid salt for use, the anodization conditions, or the like. The total amount of the acids is typically 0.01 to 10 wt.%, preferably 0.1 to 10 wt.%, and more preferably 1 to 3 wt.%.

Because of the use of an electrolyte solution containing an inorganic acid or the like having no etching effect on titanium, the anodization step of the present invention can be performed under high current and high voltage conditions.

The anodization step of the present invention is less dangerous, and does not require high current, compared with anodization accompanied by the spark discharge phenomena. Further, compared with anodization accompanied, by the spark discharge phenomena, the anodization step of the present invention can suppress an increase in the temperature of the electrolytic bath used for anodization, thus saving the cost of cooling the electrolyte solution.

Thus, compared with anodization accompanied by the spark discharge phenomena, the anodization step of the present invention can treat materials with a large area, and is advantageous from the viewpoints of economy, safety, mass production, and the like.

The titanium material with titanium nitride formed on the surface thereof obtained in the step of forming titanium nitride is immersed in a dilute electrolyte solution containing an inorganic acid or the like having no etching effect on titanium.

Subsequently, anodization is performed by applying a voltage of 10 V or more, and preferably 10 to 300 V. It is more preferable to perform anodization at a voltage of 50 to 300 V, and even more preferably 50 to 200 V.

The anodization temperature is preferably about 0 to 80°C from the standpoint of simplicity, economy, safety, and the like. It is more preferable to perform anodization at a temperature of about 10 to 50°C, and even more preferably about 20 to 30°C.

The anodization time is preferably about 1 second to 1 hour. It is more preferable to perform anodization for about 10 seconds to 30 minutes, and even more preferably about 5 minutes to 20 minutes. Anodization not involving a spark discharge is preferable because of the short anodization time and economical advantage.

(3) Step of Performing Heat Treatment

The method for producing a surface-treated metallic titanium material or titanium alloy material for an edible oil degradation-preventing member comprises the step of heating the metallic titanium material or titanium alloy material with a titanium oxide film formed on the surface thereof at a temperature of 400°C or higher in an atmosphere selected from the group consisting of an air atmosphere, a mixed atmosphere of oxygen gas and nitrogen gas, and an oxygen gas atmosphere.

Only heating the metallic titanium material or titanium alloy material forms rutile-type titanium dioxide, but does not form anatase-type titanium oxide (anatase-type titanium dioxide).

In the present invention, the titanium material with titanium nitride formed thereon or the titanium material with a titanium oxide film (amorphous titanium oxide film) formed thereon (titanium material after anodization) is heated in an oxidizing atmosphere (e.g., air oxidation treatment), thereby forming an anatase-type titanium oxide (anatase-type titanium dioxide) film useful for an edible oil degradation-preventing member. Thus, the titanium material after the heat treatment is excellent in edible oil degradation prevention characteristics.

The oxidizing atmosphere in which the heat treatment is performed may be selected from selected from (the group consisting of) an air oxidizing atmosphere, a mixed atmosphere of oxygen gas and nitrogen gas having any oxygen concentration, oxygen gas atmosphere, and the like. However, the heat treatment is preferably performed in an air oxidizing atmosphere from the standpoint of simplicity, economy, safety, and the like.

The temperature for the heat treatment in an oxidizing atmosphere is 400°C or higher from the standpoint of efficient conversion from amorphous titanium oxide to anatase-type titanium oxide. The temperature for the heat treatment in an oxidizing atmosphere is preferably about 800°C or lower to prevent a phase transition from anatase-type titanium oxide to rutile-type titanium dioxide.

This is because rutile-type titanium dioxide is less useful than anatase-type titanium oxide in preventing edible oil from degrading. The temperature for the heat treatment in an oxidizing atmosphere is particularly preferably about 400 to 700°C.

The reaction pressure for the heat treatment is about 0.01 to 10 MPa, preferably about 0.01 to 5 MPa, and more preferably about 0.1 to 1 MPa.

The heating time for the heat treatment is preferably about 1 minute to 12 hours, more preferably about 10 minutes to 8 hours, and even more preferably about 1 hour to 6 hours.

The crystalline titanium oxide film is preferably an anatase-type titanium oxide film.

(4) Edible Oil Degradation-preventing Member

The surface-treated metallic titanium material or titanium alloy material obtained by the method of the present invention can have applications in edible oil degradation-preventing members. Specifically, regardless of the type, shape, or size of the heat-cooking container, or the type of edible oil, bringing the edible oil degradation-preventing member into contact with edible oil during cooking suppresses the degradation of the edible oil, reducing increases in the acid value (AV) of the edible oil. This prevents the edible oil from thermally degrading and decreasing the flavor and nutritional value, thus increasing the lifetime of the edible oil. In addition, suppressing the degradation of edible oil prevents an increase in the viscosity of the edible oil, making the oil easy to drain. This enables the cooking of crispy deep-fried food, improving the texture of the cooked food.

The edible oil degradation-preventing reaction is a surface reaction. The more frequently the edible oil degradation-preventing member of the present invention comes into contact with edible oil, the more efficiently the degradation of the edible oil can be suppressed. It is preferable to place washed and surface-treated titanium materials packed in a bundle as an edible oil degradation-preventing member, and use a porous metallic titanium or porous titanium alloy.

When an edible oil degradation-preventing member obtained by the present invention is placed in an inner case of a fryer for use in cooking using edible oil, materials punched to provide apertures, or materials, for example, in the form of a lath, a mesh, a basket, or a pipe may be used for better circulation of edible oil during cooking. These materials that have been suitably machine-processed (e.g., folded and cut) may also be used.

Recycling of the edible oil degradation-preventing member in multiple heat-cooking containers is also possible by, after cooking, taking out the edible oil degradation-preventing member from the edible oil-containing heat-cooking container, and placing it in another heat-cooking container.

Examples of the edible oil intended in the present invention include, but are not particularly limited to, soybean oil, rapeseed oil, palm oil, olive oil, salad oil, cottonseed oil, cacao oil, sunflower oil, corn oil, rice oil, lard, sardine oil, and whale oil.

(5) Method for Treating Surface of Metallic Titanium Material or Titanium Alloy Material

Disclosed is also a method for treating the surface of a metallic titanium material or titanium alloy material for use in an edible oil degradation-preventing member.

The method for treating the surface of a metallic titanium material or titanium alloy material for use in an edible oil degradation-preventing member of the present invention comprises the steps of:

(1) forming titanium nitride on the surface of a metallic titanium material or titanium alloy material by one treatment method selected from the group consisting of a heat treatment under an ammonia gas atmosphere and a heat treatment under a nitrogen gas atmosphere, at a heating temperature of 750°C or higher;

(2) anodizing the metallic titanium material or titanium alloy material with the titanium nitride formed on the surface thereof obtained in step (1) by applying a voltage of 10 V or more in an electrolyte solution having no etching effect on titanium, thereby forming a titanium oxide film; and

(3) heating the metallic titanium material or titanium alloy material with the titanium oxide film formed on the surface thereof obtained in step (2) at a temperature of 400°C or higher in an atmosphere selected from selected from (the group consisting of) an air atmosphere, a mixed atmosphere of oxygen gas and nitrogen gas, and an oxygen gas atmosphere.

The electrolyte solution having no etching effect on titanium is preferably an electrolyte solution containing at least one compound selected from the group consisting of inorganic acids (e.g., phosphoric acid), organic acids, and salts thereof (e.g., phosphate).

Steps (1) to (3) are the same as steps (1) to (3) of the aforementioned method for producing an edible oil degradation-preventing member. The at least one compound selected from the group consisting of inorganic acids (e.g., phosphoric acid), organic acids, and salts thereof is preferably a compound having no etching effect on titanium.

Examples

The following Examples describe the present invention in detail. However, the present invention is not limited to the Examples.

Example 1

A metallic titanium plate (titanium material) was degreased with trichloroethylene.

Using a nitriding furnace (NVF-600-PC, produced by Nakanihon-Ro Kogyo Co., Ltd.), titanium nitride was formed on the surface of the degreased metallic titanium plate.

First, the metallic titanium plate was held by a plate-shaped carbon material (two or more plate-shaped carbon materials) placed in the nitriding furnace.

Subsequently, to remove oxygen, the pressure in the nitriding furnace was reduced to 1 Pa or less, and then high-purity (99.99% or more) nitrogen gas was introduced into the nitriding furnace to return the pressure to 0.1 MPa (atmospheric pressure). Reducing the pressure in the nitriding furnace to 1 Pa or less can remove oxygen in the air, preventing the oxidation of titanium, which has a high oxygen affinity.

Then, the temperature of the nitriding furnace was raised to 950°C over a period of 2 hours. Thereafter, heat treatment was performed in the nitriding furnace at 950°C for 1 hour, thereby forming titanium nitride on the surface of the metallic titanium plate.

The metallic titanium plate with titanium nitride formed on the surface thereof was immersed in a 1 wt.% phosphoric acid aqueous solution (electrolyte solution).

Then, using a function generator (HB-105, produced by Hokuto Denko Corporation) and a regulated DC power source (PU300-5, produced by Texio Technology Corporation), the voltage between an anode connected to the metallic titanium plate with titanium nitride formed on the surface thereof and a cathode connected to the carbon material was increased at 100 mV/sec.

While the voltage was maintained at 200 V for 10 minutes, the metallic titanium plate with titanium nitride formed on the surface thereof was anodized, thereby forming a titanium oxide film.

The metallic titanium plate with a titanium oxide film formed on the surface thereof was heated (air-oxidized) in the air (in an oxidizing atmosphere) at 700°C for 1 hour.

As a result of the above treatment, a metallic titanium plate (titanium material) with an anatase-type titanium oxide film formed on the surface thereof was produced. The surface-treated titanium material of Example 1 was prepared by the method comprising the steps of (1) forming titanium nitride, (2) performing anodization, and (3) performing a heat treatment.

The material (titanium material) (width 50 mm × length 50 mm × thickness 1 mm) was placed in a 500-mL tall beaker (Shibata Scientific Technology Ltd.). 150 g of soybean oil (edible oil) was added to the tall beaker.

To thermally degrade the edible oil, the tall beaker was placed in silicone oil (Wako Pure Chemical Ind. Ltd.), and maintained at 200°C with an oil bath stirrer EOS-200R (AS ONE Corporation).

Because a simple heat treatment is unlikely to promote edible oil degradation, 10 g of potatoes for deep-frying (trade name: Shoe String, Iwatani Corporation) were placed in the soybean oil every 1 hour, and taken out in 5 minutes.

The titanium material was allowed to stand in the tall beaker for 1 minute, and then the oil was collected.

5 g of the edible oil degraded through the operation described above was weighed every 6 hours, and placed in a 200-mL beaker. 100 mL of a solvent obtained by mixing ethanol (Wako Pure Chemical Ind. Ltd.) with diethyl ether (Wako Pure Chemical Ind. Ltd.) in equal amounts was placed in the beaker to dissolve the edible oil.

The amount of generated acid, such as carboxylic acid generated by thermal degradation of the edible oil or free fatty acid generated by hydrolysis of the edible oil was determined by neutralization titration using a decinormal potassium hydroxide solution (Wako Pure Chemical Ind. Ltd.) with a 1% phenolphthalein ethanol solution (Wako Pure Chemical Ind. Ltd.) as an indicator.

The acid value (AV) of the edible oil, which can be an indication of the degree of degradation of the edible oil, was determined from the following equation based on the results of this neutralization titration.

```
The acid value (AV) = the amount of dropped decinormal

potassium hydroxide (mL) × 5.611/the amount of edible oil (g)
```

To confirm the effect of the edible oil degradation-preventing member based on the present invention, the same experiment was performed by
using the same-size metallic titanium plate (indicated as □ in Fig. 1),
adding no material (indicated as ○ in Fig. 1), or
using a metallic titanium that was not treated to form titanium nitride on the surface but anodized and oxidized in an air atmosphere (indicated as △ in Fig. 1) in the same manner as in the present invention (indicated as ● in Fig. 1) .

Fig. 1 shows the results.

The results revealed that the use of the metallic titanium plate (indicated as □ in Fig. 1) and the use of the metallic titanium that was not treated to form titanium nitride on the surface but anodized and oxidized in an air atmosphere (indicated as Δ in Fig. 1) did not sufficiently prevent the degradation of edible oil.

In contrast, the results revealed that forming titanium nitride, performing an anodization treatment in an electrolyte solution having no etching effect on titanium, and performing an atmospheric oxidation treatment can sufficiently prevent the degradation of edible oil (indicated as ● in Fig. 1).

Example 2

A metallic titanium plate (titanium material) was degreased with trichloroethylene in the same manner as in Example 1.

Using a nitriding furnace (NVF-600-PC, produced by Nakanihon-Ro Kogyo Co., Ltd.), titanium nitride was formed on the surface of the degreased metallic titanium plate.

First, the metallic titanium plate was held by a plate-shaped carbon material (two or more plate-shaped carbon materials) placed in the nitriding furnace.

Subsequently, to remove oxygen, the pressure in the nitriding furnace was reduced to 1 Pa or less, and then high-purity (99.99% or more) nitrogen gas was introduced into the nitriding furnace to return the pressure to 0.1 MPa (atmospheric pressure) . Reducing the pressure in the nitriding furnace to 1 Pa or less can remove oxygen in the air, preventing the oxidation of titanium, which has a high oxygen affinity.

Then, the temperature of the nitriding furnace was raised to 950°C over a period of 2 hours. Thereafter, heat treatment was performed in the nitriding furnace at 950°C for 1 hour, thereby forming titanium nitride on the surface of the metallic titanium plate.

The metallic titanium plate with titanium nitride formed on the surface thereof was immersed in a 1 wt.% phosphoric acid aqueous solution (electrolyte solution).

Then, using a function generator (HB-105, produced by Hokuto Denko Corporation) and a regulated DC power source (PU300-5, produced by Texio Technology Corporation), the voltage between an anode connected to the metallic titanium plate with titanium nitride formed on the surface thereof and a cathode connected to the carbon material was increased at 100 mV/sec.

While the voltage was maintained at 200 V for 10 minutes, the metallic titanium plate with titanium nitride formed on the surface thereof was anodized, thereby forming a titanium oxide film.

The metallic titanium plate with a titanium oxide film formed on the surface thereof was heated (air-oxidized) in the air (in an oxidizing atmosphere) at 400 to 700°C for 1 hour.

The material (titanium material) (width 50 mm × length 50 mm × thickness 1 mm) was placed in a 500-mL tall beaker (Shibata Scientific Technology Ltd.). 150 g of soybean oil (edible oil) was added to the tall beaker.

To thermally degrade the edible oil, the tall beaker was placed in silicone oil (Wako Pure Chemical Ind. Ltd.), and maintained at 200°C with an oil bath stirrer EOS-200R (AS ONE Corporation).

Because a simple heat treatment is unlikely to promote edible oil degradation, 10g of potatoes for deep-frying (trade name : Shoe String, Iwatani Corporation) were placed in the soybean oil every 1 hour, and taken out in 5 minutes.

The titanium material was allowed to stand in the tall beaker for 1 minute, and then the oil was collected.

5 g of the edible oil degraded through the operation described above was weighed in 24 hours, and placed in a 200-mL beaker. 100 mL of a solvent obtained by mixing ethanol (Wako Pure Chemical Ind. Ltd.) with diethyl ether (Wako Pure Chemical Ind. Ltd.) in equal amounts was placed in the beaker to dissolve the edible oil. The amount of generated acid, such as carboxylic acid generated by thermal degradation of the edible oil or free fatty acid generated by hydrolysis of the edible oil, was determined by neutralization titration using a decinormal potassium hydroxide solution (Wako Pure Chemical Ind. Ltd.) with a 1% phenolphthalein ethanol solution (Wako Pure Chemical Ind. Ltd.) as an indicator. The acid value (AV) of the edible oil, which can be an indication of the degree of degradation of the edible oil, was determined from the following equation based on the results of this neutralization titration.

$$\text{The acid value (AV)} = \text{the amount of dropped decinormal}$$
$$\text{potassium hydroxide (mL)} \times 5.611/\text{the amount of edible oil (g)}$$

To compare with the product of the present invention, the same experiment was performed using metallic titanium that was not treated to form titanium nitride on the surface but anodized and oxidized in an air atmosphere in the same manner as in the present invention.

Table 1 shows the results.

Table 1

| Temperature for Atmospheric Oxidation (°C) | No titanium nitriding treatment was performed | Titanium nitriding treatment was performed |
|---|---|---|
| 400 | 0.84 | 0.73 |
| 500 | 0.84 | 0.70 |
| 600 | 0.73 | 0.56 |
| 700 | 0.73 | 0.45 |

The results revealed that the degradation of edible oil can be prevented by forming titanium nitride, then performing anodization in an electrolyte solution having no etching effect on titanium, and performing an atmospheric oxidation treatment. The results also revealed that this edible oil degradation-preventing effect can be enhanced by forming titanium nitride, then performing anodization in an electrolyte solution having no etching effect on titanium, and performing an atmospheric oxidation treatment at higher temperatures.

**Claims**

1.　A method for producing an edible oil degradation-preventing member, the method comprising the steps of:

(1) forming titanium nitride on the surface of a metallic titanium material or titanium alloy material by one treatment method selected from the group consisting of a heat treatment under an ammonia gas atmosphere and a heat treatment under a nitrogen gas atmosphere, at a heating temperature of 750°C or higher;
(2) anodizing the metallic titanium material or titanium alloy material with the titanium nitride formed on the surface thereof obtained in step (1) by applying a voltage of 10 V or more in an electrolyte solution having no etching effect on titanium, thereby forming a titanium oxide film; and
(3) heating the metallic titanium material or titanium alloy material with the titanium oxide film formed on the surface thereof obtained in step (2) at a temperature of 400°C or higher in an atmosphere selected from an air atmosphere, a mixed atmosphere of oxygen gas and nitrogen gas, and an oxygen gas atmosphere.

2.　The method for producing an edible oil degradation-preventing member according to Claim 1, wherein the heat treatment under a nitrogen gas atmosphere is performed in the presence of an oxygen-trapping agent.

3.　The method for producing an edible oil degradation-preventing member according to Claim 1 or 2, wherein the electrolyte solution having no etching effect on titanium for use in the anodization contains at least one compound selected from the group consisting of inorganic acids, organic acids, and salts thereof.

4.　The method for producing an edible oil degradation-preventing member according to Claim 3, wherein the at least one compound selected from the group consisting of inorganic acids, organic acids, and salts thereof is at least one compound selected from the group consisting of phosphoric acid and phosphate.

5.　The method for producing an edible oil degradation-preventing member according to any one of Claims 1 to 4, wherein the voltage applied in the anodization of step (2) is 50 to 300 V.

6.　The method for producing an edible oil degradation-preventing member according to any one of Claims 1 to 5, wherein the temperature of the heat treatment performed in the atmosphere of step (3) is 400°C to 700°C.

7.　The method for producing an edible oil degradation-preventing member according to any one of Claims 1 to 6, wherein the titanium oxide film formed by the anodization is a crystalline titanium oxide film.

8.　The method for producing an edible oil degradation-preventing member according to Claim 7, wherein the crystalline titanium oxide film is an anatase-type titanium oxide film.

**Patentansprüche**

1. Ein Verfahren zur Herstellung eines Elements zur Verhinderung der Zersetzung von Speiseöl, wobei das Verfahren die Schritte umfasst:

   (1) Bilden von Titannitrid auf der Oberfläche eines metallischen Titanmaterials oder Titanlegierungsmaterials durch ein Behandlungsverfahren, ausgewählt aus der Gruppe bestehend aus einer Wärmebehandlung unter einer Ammoniakgasatmosphäre und einer Wärmebehandlung unter einer Stickstoffgasatmosphäre, bei einer Erwärmungstemperatur von 750°C oder höher;
   (2) Eloxieren des metallischen Titanmaterials oder Titanlegierungsmaterials mit dem auf der Oberfläche desselben gebildeten, in Schritt (1) erhaltenen Titannitrids durch Anlegen einer Spannung von 10 V oder mehr in einer Elektrolytlösung ohne Ätzwirkung auf Titan, wodurch sich ein Titanoxidfilm bildet; und
   (3) Erwärmen des metallischen Titanmaterials oder Titanlegierungsmaterials mit dem auf der Oberfläche desselben gebildeten, in Schritt (2) erhaltenen Titanoxidfilm bei einer Temperatur von 400°C oder höher in einer Atmosphäre, ausgewählt aus einer Luftatmosphäre, einem Atmosphärengemisch aus Sauerstoffgas und Stickstoffgas, und einer Sauerstoffgasatmosphäre.

2. Das Verfahren zur Herstellung eines Elements zur Verhinderung der Zersetzung von Speiseöl nach Anspruch 1, wobei die Wärmebehandlung unter einer Stickstoffgasatmosphäre in Gegenwart eines Sauerstofffängers durchgeführt wird.

3. Das Verfahren zur Herstellung eines Elements zur Verhinderung der Zersetzung von Speiseöl nach Anspruch 1 oder 2, wobei die Elektrolytlösung ohne Ätzwirkung auf Titan zur Verwendung bei der Eloxierung mindestens eine Verbindung, ausgewählt aus der Gruppe bestehend aus anorganischen Säuren, organischen Säuren und Salzen davon, enthält.

4. Das Verfahren zur Herstellung eines Elements zur Verhinderung der Zersetzung von Speiseöl nach Anspruch 3, wobei die mindestens eine Verbindung, ausgewählt aus der Gruppe bestehend aus anorganischen Säuren, organischen Säuren und Salzen davon, mindestens eine Verbindung, ausgewählt aus der Gruppe bestehend aus Phosphorsäure und Phosphat, ist.

5. Das Verfahren zur Herstellung eines Elements zur Verhinderung der Zersetzung von Speiseöl nach einem der Ansprüche 1 bis 4, wobei die bei der Eloxierung von Schritt (2) angelegte Spannung 50 bis 300 V beträgt.

6. Das Verfahren zur Herstellung eines Elements zur Verhinderung der Zersetzung von Speiseöl nach einem der Ansprüche 1 bis 5, wobei die Temperatur der in der Atmosphäre von Schritt (3) durchgeführten Wärmebehandlung 400°C bis 700°C beträgt.

7. Das Verfahren zur Herstellung eines Elements zur Verhinderung der Zersetzung von Speiseöl nach einem der Ansprüche 1 bis 6, wobei der durch die Eloxierung gebildete Titanoxidfilm ein kristalliner Titanoxidfilm ist.

8. Das Verfahren zur Herstellung eines Elements zur Verhinderung der Zersetzung von Speiseöl nach Anspruch 7, wobei der kristalline Titanoxidfilm ein Titanoxidfilm vom Anatasetyp ist.

**Revendications**

1. Procédé pour produire un élément empêchant la détérioration d'une huile comestible, le procédé comprenant les étapes de :

   (1) formation de nitrure de titane sur la surface d'un matériau en titane métallique ou d'un matériau en alliage de titane par un procédé de traitement sélectionné à partir du groupe constitué par un traitement thermique sous atmosphère de gaz ammoniac, et par un traitement thermique sous atmosphère d'azote gazeux, à une température de chauffage supérieure ou égale à 750°C;
   (2) anodisation du matériau en titane métallique ou du matériau en alliage de titane avec du nitrure de titane formé sur la surface de celui-ci obtenu à l'étape (1) par l'application d'une tension supérieure ou égale à 10 V dans une solution d'électrolyte n'ayant aucun effet d'attaque sur le titane, formant ainsi un film d'oxyde de titane ; et

(3) chauffage du matériau en titane métallique ou du matériau en alliage de titane avec un film d'oxyde de titane formé sur la surface de celui-ci à l'étape (2) à une température supérieure ou égale à 400 °C sous une atmosphère sélectionnée à partir d'une atmosphère d'air, d'une atmosphère mixte d'oxygène gazeux et d'azote gazeux, et d'une atmosphère d'oxygène gazeux.

**2.** Procédé pour produire un élément empêchant la détérioration d'une huile comestible selon la revendication 1, dans lequel le traitement thermique sous atmosphère d'azote gazeux est mis en oeuvre en présence d'un agent de captage d'oxygène.

**3.** Procédé pour produire un élément empêchant la détérioration d'une huile comestible selon la revendication 1 ou 2, dans lequel la solution d'électrolyte n'ayant aucun effet d'attaque sur le titane destinée à être utilisée dans l'anodisation contient au moins un composé sélectionné à partir du groupe constitué par des acides inorganiques, des acides organiques et des sels de ceux-ci.

**4.** Procédé pour produire un élément empêchant la détérioration d'une huile comestible selon la revendication 3, dans lequel l'au moins un composé sélectionné à partir du groupe constitué par des acides inorganiques, des acides organiques, et des sels de ceux-ci est au moins un composé sélectionné à partir du groupe constitué par de l'acide phosphorique et du phosphate.

**5.** Procédé pour produire un élément empêchant la détérioration d'une huile comestible selon l'une quelconque des revendications 1 à 4, dans lequel la tension appliquée dans l'anodisation de l'étape (2) va de 50 à 300 V.

**6.** Procédé pour produire un élément empêchant la détérioration d'une huile comestible selon l'une quelconque des revendications 1 à 5, dans lequel la température du traitement thermique mis en œuvre sous l'atmosphère de l'étape (3) va de 400 °C à 700 °C.

**7.** Procédé pour produire un élément empêchant la détérioration d'une huile comestible selon l'une quelconque des revendications 1 à 6, dans lequel le film d'oxyde de titane formé par l'anodisation est un film d'oxyde de titane cristallin.

**8.** Procédé pour produire un élément empêchant la détérioration d'une huile comestible selon la revendication 7, dans lequel le film d'oxyde de titane cristallin est un film d'oxyde de titane du type anatase.

Fig. 1

-○-: No Addition of Titanium Material
-□-: Metallic Titanium
-△-: Anodization
    + Atmospheric Oxidation at 700°C for 1 Hour
-●-: Nitriding Treatment   + Anodization
    + Atmospheric Oxidation at 700°C for 1 Hour

AV (Acid Value) Increase

Heating Time (Hr)

**EP 3 088 568 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H0919612 A
- JP 2011200406 A
- US 20130186813 A